# EUROPEAN PATENT APPLICATION

(11) **EP 1 343 230 A1**
(43) Date of publication of application: **10.09.2003**
(21) Application number: 02251687.6
(22) Date of filing: 09.03.2002
(51) Int. Cl.: H01S 5/223

(54) **Single transverse mode semiconductor laser**

(71) Applicant: Agilent Technologies, Inc. (a Delaware corporation), Palo Alto, CA 94303 (US)
(72) Inventor: Helmy, Amr, Ipswich 4IP 2SG (GB)
(74) Representative: Coker, David Graeme

(57) **Abstract**

The present invention provides a semiconductor laser device that comprises quantum wells disposed perpendicular to the light generated by the semiconductor laser device. The quantum wells allows the fundamental mode generated by the laser to pass through almost substantially unaffected whilst attenuating the higher-order modes.

## Description

This invention relates to the field of lasers and in particular to laser structures that enable increased optical power outputs.

Erbium doped semiconductor amplifiers (EDFAs) are now common in modern optical communications systems and are used to increase the strength of signals launched into an optical fibre by a transmitter, to boost signals at intermediate repeater stations or to pre-amplify received signals prior to their detection. In order to maintain the amplification process the EDFAs must be pumped with a relatively high optical power signal. The wavelength of the pump signal has an influence on the operation of the EDFA, with a pump signal of around 980 nm giving a low-noise amplifier having an adequate optical gain and a pump signal of approximately 1480 nm giving a high gain amplifier with an adequate noise performance. Hybrid pump systems have also been used, with a number of pump lasers such that signals of both 980 nm and 1480 nm are present. This arrangement leads to an optical amplifier that has good optical gain and good noise performance.

For reliable operation of pump lasers, and hence of the associated EDFAs, it is important that lasing is only obtained for the first lateral mode across the full operating range of the pump laser. This requirement is particularly important for 980 nm pump lasers for use in low noise amplifiers. This limited lasing can be obtained at moderate and low current injection levels by carefully designing the vertical and lateral waveguide profiles of the laser structure. However, at the typical operating currents of such lasers substantial thermal effects govern much of the optical confinement and hence induce effects such as thermal lensing. Higher order transverse modes can therefore be excited at high pumping currents, and hence make single lateral mode operation a challenging task.

A number of techniques have been employed in an attempt to prevent higher order modes from lasing in laser structures when operating at high currents. J. K. Lee et al ("*Improvement of Kink and Beam Steering Characteristics of 0.98 mm GaInAs-GaInP High-Power Lasers utilizing Channel Ion Implantation*", IEEE Phot Tech Lett, vol 12, P 140, 2000) suggest the implantation of ions in the regions next to the lasing stripe in order to increase higher-mode losses but it is thought that this may jeopardise the reliability of devices produced in this way. K. Hiramoto *et al* ("*High-Power and Highly Reliable Operation of Al-Free InGaAs-InGaASP 0.98 mm Lasers with a window structure fabricated by Si ion implantation*", *IEEE J. Selec.* Top. Quantum Electronics, vol 5, P 817, 1999) report the use of structures that enable higher order modes to diffract and thus exit the active region but this technique requires more complex fabrication processes with a potential decrease in device yield.

A further technique (JWR ten Cate et al, Appl. Phys. Lett., vol , P 19, 1997) attempts to alter the laser cavity length so as to provide destructive interference for the mode that is most likely to lase after the fundamental mode, but this solution will be difficult to manufacture and does not address other higher order modes that may lase. SD DeMars et al ("*Angled-grating distributed feedback laser with* 1 *W cw single-mode diffraction limited output at 980 nm*" IEEE Lasers and Electro-Optics Annual Meeting, vol. 9, p77, 1996) propose the use of angled gratings with DFB-like lasers such that lateral optical confinement is applied to the fundamental mode and the other modes are diffracted. Whilst this technique is efficient, the fabrication of the grating adds greatly to the complexity of the device.

US 5 675 601 discloses a semiconductor laser that comprises quantum wells (QWs) that are disposed in a plane that is parallel to the plane that the light lases, such that the QWs absorb some of the higher-order modes as these are less well confined than the fundamental mode. US 5 606 570 discloses an anti-guided laser array in which an absorbing layer is placed between the elements of the array to insure that the preferred array mode is the one with the lowest losses, and hence lowest threshold.

According to a first aspect of the invention there is provided a semiconductor laser device comprising an active laser region and a planar attenuation region, the active laser region, in use, generating an optical signal comprising a plurality of modes and the planar attenuation region, in use, filtering the optical signal such that one mode is attenuated substantially less than one or more of the other modes characterised in that the planar attenuation region is substantially perpendicular to the direction of propagation of the optical signal. One mode may be substantially unattenuated whilst one or more of the other modes are attenuated. Preferably the fundamental mode is attenuated substantially less than one or more of the other modes. The difference between the attenuation of the fundamental mode and the one or more of the other modes is between 2-10 dB and preferably the difference between the attenuation of the fundamental mode and the one or more of the other modes is substantially 5 dB. The planar attenuation region preferably comprises one or more quantum wells and may additionally comprise an aperture which is aligned with the active laser region.

According to a second aspect of the invention there is provided a pump laser module comprising a semiconductor laser device according to the first aspect of the invention.

According to a third aspect of the invention there is provided a method of generating an optical signal, the method comprising the steps of: (i) generating an optical signal comprising a plurality of modes; (ii) filtering the optical signal such that one mode is attenuated substantially less than one or more of the other modes, the method being characterised in that the planar attenuation region is substantially perpendicular to the direction of propagation of the optical signal.

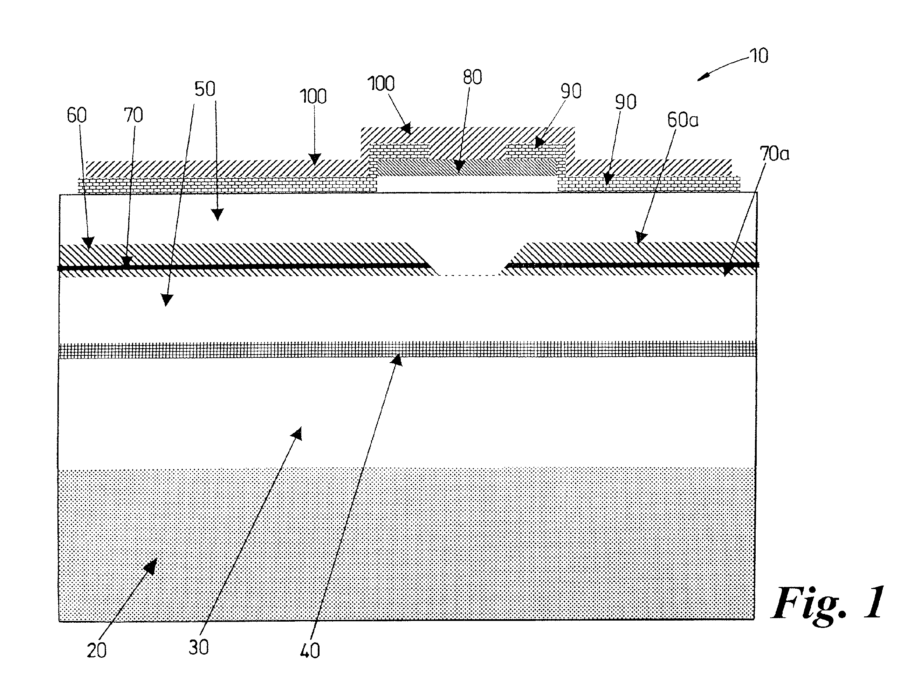

Figure 1 shows a schematic depiction of a semiconductor laser device according to the present invention. The semiconductor laser device 10 comprises a substrate 20, a lower cladding layer 30, an active region 40 and an second cladding layer 50. The semiconductor laser device 10 may be, for example, a p-i-n structure where the lower cladding layer 30 comprises p-type dopants, the active layer 40 is substantially undoped and the upper cladding layer 50 comprises n-type dopants. The upper cladding layer 50 further comprises blocking layers 60a, 60b that serve to block current leakage and to define spatially the optical output from the active region. These blocking layers comprise quantum well (QW) structures 70a, 70b that are designed to attenuate some of the higher order optical modes generated within the laser. Careful choice of the QW material, its thickness and its distance from the active region of the laser enables the first order mode (and subsequent higher order modes) to be attenuated at a significantly greater level than the fundamental mode is. As the first order mode is the most prominent of the higher order modes, in most cases it will be most efficient to attenuate the first order mode; there may be some cases where attenuation of the second (or higher) order modes is preferable. The semiconductor laser device additionally comprises a dielectric layer 90 and a contact layer 80, through which electrical connections may be made to the laser device. A layer of gold 100 is applied to the dielectric layer and the contact layer to improve the conductivity of any electrical connections made to the laser device.

The principle of the present invention is to introduce a preferential absorption loss in the structure, which predominantly affects the higher order, i.e. all but the fundamental, modes of the waveguide of the laser. The preferential absorption is implemented using a quantum well structure placed within, or just underneath the current blocking layer of the laser device, which includes at least one overgrowth stage. Higher order propagation modes will have an overlap integral higher than that of the fundamental mode, leading to extra losses that will increase the lasing threshold of any higher order mode in comparison to that of the fundamental mode. The ratio of absorption losses of the fundamental mode and the higher order modes can be controlled by engineering the refractive index profile of the waveguide structure and/or the position of the absorbing layer.

The absorption is achieved using QWs, which will have a large absorption coefficient with minimal refractive index change, and hence minimal change to the as-grown waveguiding profile. This feature is very important to attain high power and high temperature operation with stable output beam profile. The benefit of the invention is that it will insure the laser operation in the lowest order propagation mode up to very high power levels without introducing any substantial excess losses for the fundamental mode. This will hence provide the highest infibre power performance, and reliability.

In any structure that involves one or more overgrowth techniques, a quantum well can be grown within the lateral blocking and/or waveguiding region. A QW can be etched in the subsequent etch and re-growth steps, and hence will not affect the vertical structure of the laser. By tailoring the properties of this QW, its energy can be tuned to absorb the laser light emitted by the structure's active region. Also, by adjusting the position of the QW and the refractive index step in the waveguiding structure, the attenuation incurred by the higher order modes relative to that incurred by the fundamental mode can be controlled.

The figure of merit for the QW is the ratio of overlap between the higher order modes with the absorbing region to that of the fundamental mode with the absorbing region. Maximising this figure of merit means highly suppressing the threshold gain for lasing of any higher order mode in comparison to the fundamental lasing mode without significantly compromising the fundamental lasing mode efficiency and threshold performance. These goals can be achieved through the choice of materials and dimensions used.

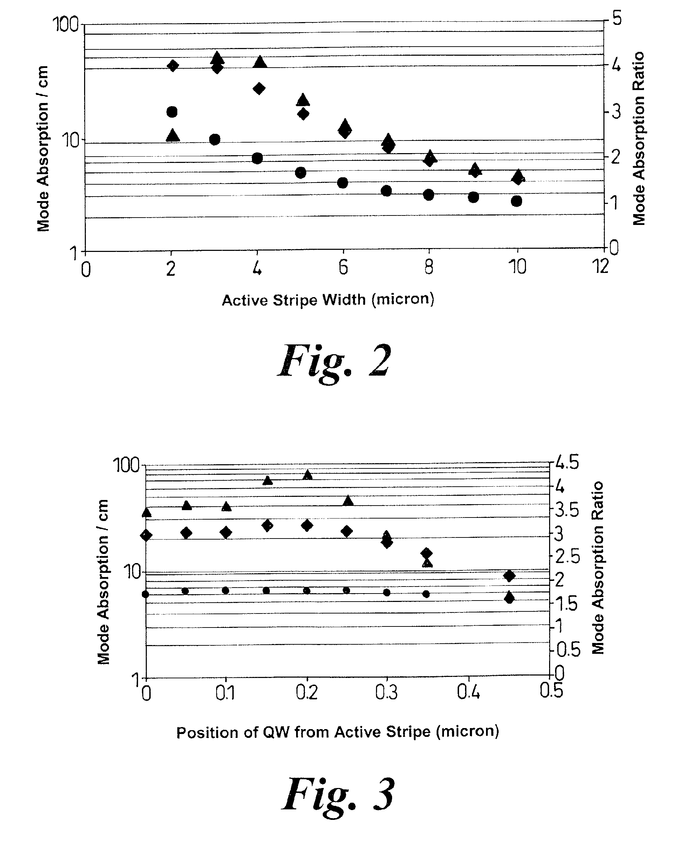

Figures 2 to 7 show exemplary calculated data that indicate factors that should be considered when designing a QW structure in order to make a semiconductor laser device according to the present invention. For these Figures, the absorption for the fundamental and first order modes is shown on the left-hand vertical axis using a logarithmic scale, and the ratio of the first order mode absorption to the second order mode absorption is shown on the right-hand vertical axis using a linear scale. The horizontal grid lines shown in the graphs relate to the left-hand vertical axis. The data points for the fundamental modes are represented using circles, the data points for the first order mode are represented using parallelograms and the ratio between the two modes is represented using a triangle. The data were calculated assuming that the laser devices were self-aligned stripe laser devices.

Figure 2 shows the variation in mode absorption for a range of lasers with active stripes of different widths (across a range of 2 to 10 µm). The general trend is that the mode absorption decreases as the width of the active size increases, but with a pronounced maximum in the absorption ratio for an active stripe width of around 3-4 µm. Operating a laser at this maximum can provide an increased separation between the lasing threshold of the first mode and the fundamental mode.

Figure 3 shows the variation in mode absorption with the distance between the active stripe and the quantum well structure. It can be seen that the absorption of the fundamental mode is essentially constant and that the absorption of the first mode decreases for longer separation values. The absorption ratio shows a peak for a separation value of approximately 0.2 µm. This figure will tend to vary with the design of the QW structure and the materials used to form it.

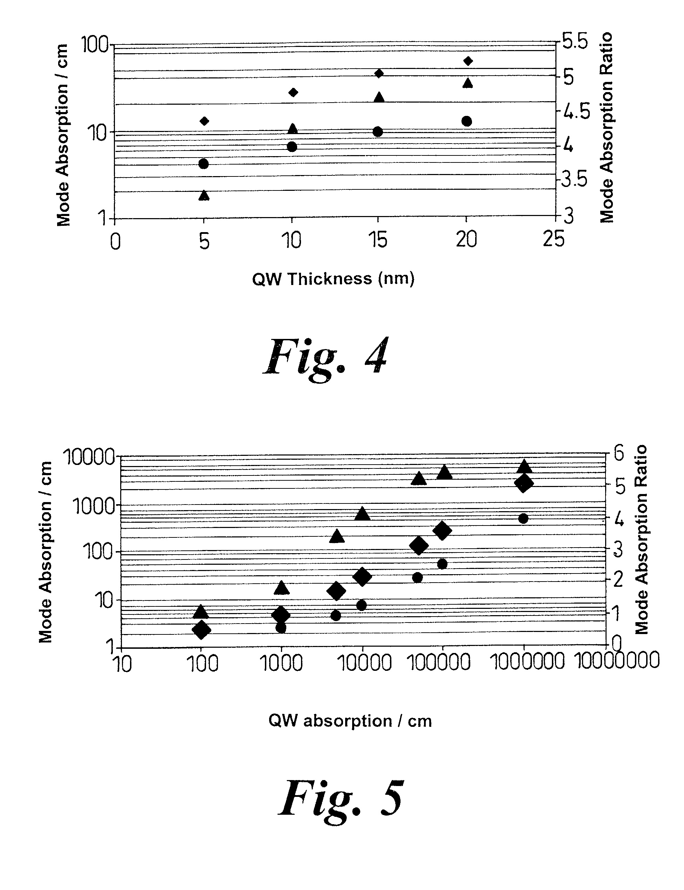

Figure 4 shows variation in mode absorption with the thickness of the QW structure. The absorption of the first mode and of the fundamental mode both increase with the thickness of the QW structure, as would be expected, although the rate of increase is greater for the absorption of the first mode. It follows that the absorption ratio increases with increasing QW structure thickness. As the function of the present invention is to provide a semiconductor laser device that can produce a high-power fundamental mode with reduced interference from the higher order modes it is important that a compromise QW thickness be selected so that the output power of the laser is adequate, without allowing significant levels of interference from higher order modes.

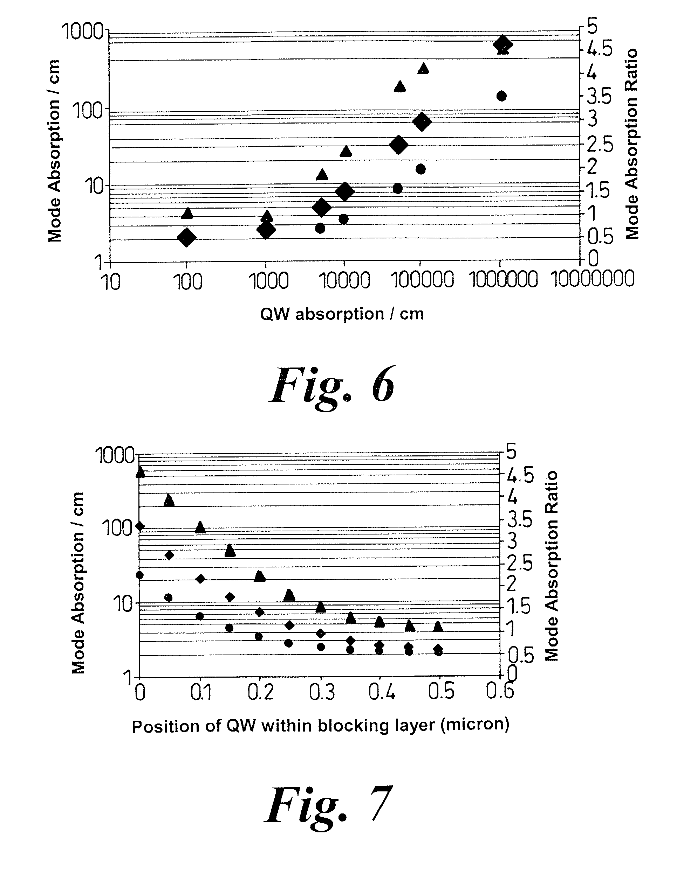

Figure 5 shows the variation in mode absorption with the absorption of the QW material for a laser having an active stripe with a width of 4µm. Again, the absorption of the first mode and of the fundamental mode both increase with the increasing QW absorption, although the absorption of the first mode increases at a much greater rate as the absorption ratio increases from approximately unity to about 5.5 as the absorption increases from 100 to 10⁶/cm. Again, the choice of QW absorption value is a compromise between attenuating the fundamental mode and the first mode. Figure 6 shows the same variation shown in Figure 5 but for a laser having an active stripe with a width of 7µm. The graph shows similar trends to those shown in Figure 5 and described above, although the absorption ratio does not increase by quite as much.

Figure 7 shows the variation in mode absorption with the depth of the quantum well within its respective blocking layer. The absorption of both the fundamental mode and the first order mode decreases as the QW is moved deeper into the blocking layer, with the absorption ratio tending towards unity as the QW is moved deeper into the blocking layer.

The capability of the QW layer to selectively attenuate the higher order modes is increased by the characteristics of semiconductor laser diodes. As the bias current in a semiconductor laser diode is increased, the voltage across the junction of the diode increases. This voltage increase will affect the band-edge of the QW, and as the QW is reverse-biased will cause the absorption spectrum to shift towards shorter wavelengths. Additionally, as the increased bias current causes the temperature of the active region to rise, the lasing wavelength of the laser increases. These two effects combine so that absorption of the laser light by the QW increases as the bias current is increased. This has the advantageous benefit that at low bias currents, where it is unlikely that there will be significant higher order modes present, the absorption of the QW will be low. As the bias current increases, and the likelihood of higher order modes being present increases, then the absorption of the QW will increase, selectively attenuated the higher order modes in preference to the fundamental mode. This is reinforced by the action of the increased bias current causing the fundamental mode to be more strongly guided within the active region, further reducing the attenuation of the fundamental mode by the QW.

Although the foregoing discussion has assumed the use of a quantum well to attenuate the higher order modes, it is also possible to achieve this result using bulk semiconductor materials. However, if a bulk absorbing layer is used, then when high levels of power are absorbed by the layer changes in temperature will lead to a change in the layer's refractive index, affecting the operation of the absorbing layer. These problems can be mitigated by using a QW layer, which also provides extra degrees of freedom when designing the absorbing structure, since the thickness of the QW, and hence its bound energies, can be controlled. It will be readily understood that the present invention can be implemented in virtually all types of laser device structures with at least one overgrowth layer. The invention can also be implemented in almost all materials systems, although clearly these systems will have to be compatible with QW structure formation if the higher mode blocking layers are to be formed from QWs.

## Claims

1. A semiconductor laser device (10) comprising an active laser region (40) and a planar attenuation region (70, 70a), the active laser region generating an optical signal comprising a plurality of modes and the planar attenuation region filtering the optical signal such that one mode is attenuated substantially less than one or more of the other modes
**characterised in that** the planar attenuation region is substantially perpendicular to the direction of propagation of the optical signal.

2. A semiconductor laser device (10) according to claim 1, wherein one mode is substantially unattenuated whilst one or more of the other modes are attenuated.

3. A semiconductor laser device (10) according to claim 1 or claim 2, wherein the fundamental mode is attenuated substantially less than one or more of the other modes.

4. A semiconductor laser device (10) according to claim 3 wherein the difference between the attenuation of the fundamental mode and the one or more of the other modes is between 2-10 dB.

5. A semiconductor laser device (10) according to claim 4 wherein the difference between the attenuation of the fundamental mode and the one or more of the other modes is substantially 5 dB.

6. A semiconductor laser device (10) according to any of claims 1 to 5, in which the planar attenuation region (70, 70a) comprises one or more quantum wells.

7. A semiconductor laser device (10) according to any of claims 1 to 6, in which the planar attenuation region (70, 70a) comprises an aperture which is aligned with the active laser region (40).

8. A pump laser module comprising a semiconductor laser device according to any of claims 1 to 7.

9. A method of generating an optical signal, the method comprising the steps of
(i) generating an optical signal comprising a plurality of modes
(ii) filtering the optical signal such that one mode is attenuated substantially less than one or more of the other modes,
the method being **characterised in that** the planar attenuation region is substantially perpendicular to the direction of propagation of the optical signal.
